(19) Europäisches Patentamt
European Patent Office
Office européen des brevets

(11) **EP 3 217 424 B1**

(12) **EUROPEAN PATENT SPECIFICATION**

(45) Date of publication and mention
of the grant of the patent:
**17.04.2019 Bulletin 2019/16**

(21) Application number: **15856293.4**

(22) Date of filing: **06.11.2015**

(51) Int Cl.:
*H01L 21/52* (2006.01)        *B22F 7/08* (2006.01)
*B23K 20/00* (2006.01)        *C22C 1/08* (2006.01)
*H01B 5/16* (2006.01)

(86) International application number:
**PCT/JP2015/081405**

(87) International publication number:
**WO 2016/072517 (12.05.2016 Gazette 2016/19)**

(54) **ELECTROCONDUCTIVE ASSEMBLY FOR ELECTRONIC COMPONENT, SEMICONDUCTOR DEVICE IN WHICH SAID ASSEMBLY IS USED, AND METHOD FOR MANUFACTURING ELECTROCONDUCTIVE ASSEMBLY**

ELEKTRISCH LEITFÄHIGE ANORDNUNG FÜR ELEKTRONISCHE KOMPONENTE, HALBLEITERBAUELEMENT MIT DER ANORDNUNG UND VERFAHREN ZUR HERSTELLUNG EINER ELEKTRISCH LEITFÄHIGEN ANORDNUNG

ENSEMBLE ÉLECTRO-CONDUCTEUR POUR COMPOSANT ÉLECTRONIQUE, DISPOSITIF À SEMI-CONDUCTEUR DANS LEQUEL LEDIT ENSEMBLE EST UTILISÉ, ET PROCÉDÉ DE FABRICATION D'ENSEMBLE ÉLECTRO-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.11.2014 JP 2014227065**

(43) Date of publication of application:
**13.09.2017 Bulletin 2017/37**

(73) Proprietor: **Nippon Steel & Sumitomo Metal Corporation**
**Tokyo 100-8071 (JP)**

(72) Inventors:
• **MATSUBARA, Norie**
**Tokyo 100-8071 (JP)**
• **ISHIKAWA, Shinji**
**Tokyo 100-8071 (JP)**
• **UNO, Tomohiro**
**Tokyo 100-8071 (JP)**

• **SHIMIZU, Takayuki**
**Kisarazu-shi**
**Chiba 292-0835 (JP)**
• **KITAMURA, Naoya**
**Kisarazu-shi**
**Chiba 292-0835 (JP)**

(74) Representative: **Vossius & Partner**
**Patentanwälte Rechtsanwälte mbB**
**Siebertstrasse 3**
**81675 München (DE)**

(56) References cited:
EP-A1- 3 016 135        WO-A1-2011/114747
JP-A- S63 186 434        JP-A- 2007 083 288
JP-A- 2013 068 343        JP-A- 2014 030 829
JP-A- 2014 127 535        JP-A- 2014 162 966
JP-A- 2014 162 967        JP-A- 2014 188 561
US-A- 5 360 991          US-A1- 2005 003 677

**Description**

Technical Field

The present invention relates to a conductive bonded assembly used in a semiconductor device (device) such as a power semiconductor device (device) and various other electronic components. In particular, it relates to a conductive bonded assembly forming a conductive bonding layer substantially without pressing and a method of production of the same.

Background Art

In recent years, in the automobile, industrial equipment, and other various fields, various types of control units and other electronic components have been actively made use of with the aim of increasing safety, saving energy, and countering global warming, etc. For example, in the hybrid vehicles or electric vehicles, considered promising for countering global warming, power semiconductor devices are mounted as inverters etc. of motor control systems enabling operation under high voltage and large current conditions. Further, as such power semiconductor devices, single-sided heat dissipating types and double-sided heat dissipating types are known. Power semiconductor devices have power semiconductor devices having silicon (Si), silicon carbide (SiC), silicon germanium (SiGe), and other substrates and have circuit patterns having Cu or a Cu alloy, Al or an Al alloy, and other conductor metals as substrates and lead frames and other structures bonded with electrode plates through conductive bonding layers (conductive bonded assemblies).
Power semiconductor devices, for example, like the power semiconductor devices mounted in vehicles, are sometimes used under harsh environments. For this reason, in addition to art for realizing higher density mounting for achieving smaller size or faster speed, art is being sought for realizing further improved performance such as tolerance against tough environments and reliability. In particular, at the bonding layers of power semiconductor devices, high heat resistance enabling use in the engine compartment to be withstood is being sought. Furthermore, absorption of the difference in coefficient of thermal expansion between the silicon (Si), silicon carbide (SiC), etc. of the substrate of semiconductor devices and the copper (Cu), aluminum (Al), etc. of the substrate of the electrode plates is being sought. For example, there are many opportunities for exposure to large temperature changes due to changes in the ambient temperature as a result of the seasons or daytime/nighttime or periodic heating and cooling due to operation and shutdown. When exposed to such large temperature changes, due to the difference in the coefficients of thermal expansion, the bonding layers are sometimes acted on by a large thermal stress. As a result, the bonding strength at the bonding layers falls, the semiconductor device or electrode plate warps, and further separation of the semiconductor device and electrode plate, cracking, or other problems occur and in turn cause breakdown.
Therefore, in current mounting technology, to satisfy the high heat resistance, environmental tolerance, high reliability, etc. demanded from such power semiconductor devices, in particular their bonding layers, high temperature solder containing lead in a high concentration is used. However, since this lead-rich high temperature solder contains lead in a high concentration, there are problems such as environmental pollution. Further, there is the problem that, due to its melting point being 183°C or so at the highest, it is not possible to take advantage of the characteristics of a silicon carbide (SiC) substrate excellent in heat resistance so as to realize high temperature mounting enabling operation at a high temperature of 200°C or more. For this reason, in recent years, to solve the problems of making the bonding layers free of lead and realizing high temperature mounting, development of alternative materials has been strongly sought. This is becoming one of the most pressing challenges to be met. For this reason, efforts have begun to realize lead-free bonding layers and high temperature mounting of such power semiconductor devices etc. Various proposals have been made up to now.
PLT 1 proposes conductive connecting members (bonding layers) such as conductive bumps bonding gold sputtered Si chips or other semiconductor chips, conductive die bond parts bonding semiconductor chips and DBC substrates (direct bonding copper substrates) or other conductive substrates (electrode plates). That is, it proposes using a conductive paste containing metal particles comprised of two types of fine particles with different mean primary particle diameters (in the examples, silver fine particles or copper fine particles are used) to form a conductive connecting member (bonding layer) comprised of a metal porous body (sintered body obtained by firing metal fine particles in conductive paste) to thereby suppress coarse voids or cracks and obtain excellent thermal cycle characteristics, crack resistance, and bonding strength.
PLT 2 proposes a conductive paste used when forming conductive bumps (bonding layer) or conductive die bond parts (bonding layer) comprised of a metal porous body of a sintered body of metal fine particles (in the examples, copper fine particles are used) into which a bumping-suppressing solvent or evaporation-suppressing solvent having a specific molecular structure is mixed. Due to this, it is considered that the solvent added to the conductive paste or water contained in the conductive paste due to absorption of moisture before use prevents bumping at the time of heating and sintering the metal fine particles and enables the production of a homogeneous metal porous body having a porosity of 5 to 15% and free of cracks or voids of a size of 10 μm or more.

PLT 3 proposes use of a bonding material containing a metal particle precursor comprised of silver carbonate or silver oxide and a reducing agent of silver acetate or other carboxylic acid metal salt particles when producing a semiconductor device bonding an Si MOSFET chip or other semiconductor chip and a copper or other electrode interconnect provided at the surface of a ceramic insulating substrate through a sintered silver layer. Due to this, it is possible to realize bonding by metal bonds at the bonding interface at a lower temperature. For example, application becomes possible to bond an electrode provided on an active area of a semiconductor chip and a mounting part of a circuit board mounting the same. It is considered that the bonding layer after bonding has a higher heat resistance compared with a conventional solder material so a smaller size and higher reliability can be realized.

PLT 4 proposes a sintered metal layer in a semiconductor device bonding a semiconductor chip and an electrode plate on an insulating substrate through a silver or copper sintered metal layer which is increased in porosity in the sintered metal layer in the region less than 0.5 mm from the end parts of the semiconductor chip over the porosity in the sintered metal layer at the region 0.5 mm or more inside from the end parts of the semiconductor chip. Due to this, it is considered possible to ease the stress at the end parts of the bonding layer and realize higher strength bonding and higher heat dissipation.

However, in the inventions described in PLTs 1 to 4, even if it is possible to achieve the respectively targeted bonding strengths or other performances by modifying the respective sintered bonding layers comprised of the silver or copper sintered bodies, to realize the desired bonding strengths by these silver or copper sintered bonding layers in a semiconductor device for example, it is essential to sandwich a paste containing metal fine particles of silver or copper between the semiconductor device, semiconductor chip, or other semiconductor component and the electrode plate or other metal member to be bonded with each other by the conductive bonding layer and heat the assembly while pressing it to fire and sinter the metal fine particles to form the sintered bonding layer.

PLT 6 discloses a paste-like heating and bonding material obtained by mixing metal particles with primary particles of a particle diameter of 5 to 200 nm and metal particles with primary particles of a particle diameter of 1 to 20 μm in an organic compound solvent containing a polyol. It describes that this is an alternative to solder paste for bonding the same types or different types of metal members, semiconductor members, or other members and that since solid at ordinary temperature, if forming a patterned shape, it is possible to arrange (mount) it at a predetermined position. It describes that due to this, a bonding material with a higher bonding strength than plating or sputtering and with a good storability is obtained. However, the method of bonding a semiconductor chip on which this bonding material is placed with a lead frame or other electrode material is the same as the past. That is, the members are heat treated while being pressed for bonding.

For this reason, when pressing force cannot be applied from the outside in the process of firing metal fine particles to form a sintered bonding layer, it is necessary to rely on the conventional lead-rich high temperature solder. This has become a major obstacle to elimination of lead use. Therefore, in the past as well, experiments have started to be proposed for sandwiching paste containing metal fine particles between a semiconductor chip and metal member and heating these under non-pressing conditions to fire the metal fine particles and form a sintered bonding layer.

PLT 5 uses a silver-based powder with a mean particle diameter of less than 10 nm containing an organic component and silver (first powder), a silver-based powder with a mean particle diameter of 40 nm or more (in general, 400 nm or less) (second powder), and a silver-based powder having a mean particle diameter between the first powder and the second powder (third powder) to prepare a paste 1 containing the above the first powder, second powder, and third powder and a paste 2 containing the first powder and second powder, uses the pastes 1 and 2 to conduct bonding tests under conditions without pressing from the outside and with only self weight, and reports that compared with a comparative paste of only the first powder, the bonding strength at a heat treatment temperature of 300 to 350°C is improved slightly with the paste 2 and remarkably with the paste 1.

However, when using silver fine particles as metal fine particles for forming a sintered bonding layer, there is the problem of ease of corrosion in a sulfur-containing atmosphere. Furthermore, there is the separate problem that among metals excellent in conductivity, "silver is a metal in which the problems of electron migration or ion migration easily occur". That is, the "problem of electron migration" is the problem that metal ions move in the direction of the flow of current when running current to a conductor and cause formation of voids at the cathode side leading to an open circuit and, further, cause growth of hillocks or whiskers at the anode side leading in the end to a short-circuit. Further, the problem of ion migration easily occurs due to use in a high humidity and is a problem based on the electrolysis phenomenon where due to the effects of the electric field, the metal components move across the non-metal medium and reprecipitate at the destination. Both are known as causes for short-circuits in semiconductor devices.

Further, when using copper fine particles as metal fine particles for forming a sintered bonding layer, there is the problem that during the high temperature operation of the semiconductor chip, the oxidation of the copper itself can progress and cause a drop in the coefficient of thermal expansion and reliability.

Citation List

Patent Literature

PLT 1: Japanese Patent No. 5041454B3
PLT 2: Japanese Patent Publication No. 2013-069475A
PLT 3: Japanese Patent Publication No. 2012-094873A
PLT 4: Japanese Patent Publication No. 2014-029897A
PLT 5: Japanese Patent Publication No. 2011-175871A
PLT 6: Japanese Patent Publication No. 2013-177618A

Summary of Invention

Technical Problem

The present invention has as its problem the solution of the various problems in a conductive bonded assembly provided with the above-mentioned silver or copper sintered bonding layer, more particularly has as its object to obtain a conductive bonded assembly having excellent bonding strength even if between a silicon or other semiconductor substrate and an electrode plate, provided with both an excellent electron migration characteristic and ion migration characteristic, and able to be fired under non-pressing conditions.

Solution to Problem

The inventors engaged in in-depth studies to solve this problem and obtained the following findings:

(a) It was discovered that by using conductive metal particles comprised of particles of Ni (nickel) or a Ni alloy (below, in this Description, simply referred to as "Ni particles") and heating and sintering them without pressing (under non-pressing conditions), it is possible to obtain a good sintered body.
Furthermore, it was confirmed that with a sintered body comprised of Ni particles, good bonding strength can be secured with a bondable member of a semiconductor chip on the Si or SiC substrate material (for example, metal film obtained by vapor deposition (sputtering) of metal) or Cu or other metal material etc.
Further, it was discovered that a sintered body comprised of Ni particles is also excellent in electron migration characteristic and ion migration characteristic.
That is, it was discovered that by sandwiching Ni particles between the bondable member and firing them under non-pressing conditions to form the bonding layer, it is possible to obtain a conductive bonded assembly having an excellent bonding strength.
(b) It was discovered that by controlling the porosity in the bonding layer of the conductive bonded assembly to within a predetermined range, it is possible to suppress a drop in bonding strength and further raise the heat dissipation to secure the heat resistance. That is, the porosity due to voids of a circle equivalent diameter of 1 $\mu$m or more in any cross-section in the bonding layer (micron size or more porosity) should be made 30% or less.
(c) Furthermore, it was discovered that the porosity due to voids of a circle equivalent diameter of less than 1 $\mu$m in any cross-section in the bonding layer (submicron size or less porosity) should also be suitably controlled. That is, it was discovered that by making the submicron size porosity 1% to 50%, it is possible to improve the sinterability and furthermore possible to keep down the drop in bonding strength.
(d) It was discovered that, in order to make the porosity a suitable one, the particle diameter distribution of Ni particles should be controlled. That is, it was learned that nanoparticles (Pn) of a mean particle diameter of 70 nm to 100 nm and microparticles (Pm) of a mean particle diameter of 0.5 $\mu$m to 10 $\mu$m should be blended by a suitable ratio. That is, it was discovered that when defining the cross-sectional area of the nanoparticles (Pn) as "Sn" and the cross-sectional area of the microparticles (Pm) as "Sm", the value of Sn/(Sn+Sm) should be 0.2 to 0.8.
(e) It was discovered that by coating a binder containing Ni particles and an organic solvent on one bondable member and making it dry first, then coating a binder on the part corresponding to the bonding surface with the other bondable member, joining these bondable members, and heating them to fire them, it is possible to obtain a sintered body between the bondable members without pressing.
The present invention was made based on the above discoveries and has as its gist the following:

(1) A conductive bonded assembly of an electronic component having a first bondable member, a second bondable member, and a conductive bonding layer positioned between the first bondable member and the second bondable member and bonding the two bondable members, in which conductive bonded assembly of an electronic component, the bonding layer is a sintered body of particles of one or both of nickel or a nickel alloy, and, in any cross-section in the bonding layer, a porosity of voids having a circle equivalent diameter of less than 1 $\mu$m is 30% or less and a porosity of voids having a circle equivalent diameter of less than 1 $\mu$m is 1% to 50%, wherein as the particles of nickel or a nickel alloy forming the bonding layer, nanoparticles (Pn) of a mean particle diameter of 15 nm to 150 nm measured by SEM observation and microparticles (Pm) of a mean particle diameter of 0.5 $\mu$m to 10 $\mu$m measured by SEM observation are copresent, and when a cross-sectional area of the nanoparticles (Pn) is Sn and a cross-sectional area of the microparticles (Pm) is Sm, the value of Sn/(Sn+Sm) is 0.2 to 0.8.

(4) The conductive bonded assembly of an electronic component according to any one of (1) to (3), wherein at a bonding surface of the first bondable member or second bondable member with the bonding layer, a contact area of the first bondable member or second bondable member with the bonding layer is 90% or more of the bonding surface by observation by X-ray fluoroscopic image.

(5) The conductive bonded assembly of an electronic component according to any one of (1) to (4), wherein at a bonding surface of the first bondable member or second bondable member with the bonding layer, there is no non-contact part of a size of a circle equivalent diameter of 1 mm or more by observation by X-ray fluoroscopic image.

(6) A semiconductor device provided with a conductive bonded assembly according to any one of (1) to (5), wherein the first bondable member is a metal member and, further, the second bondable member is a semiconductor chip having silicon or silicon carbide as a substrate.

(7) A method of production of a conductive bonded assembly of an electronic component having a first bondable member, a second bondable member, and a conductive bonding layer positioned between the first bondable member and the second bondable member and bonding the two bondable members through bonding surfaces, the method of production of a conductive bonded assembly of an electronic component comprising a coating layer forming step of coating at least one bonding surface of the first bondable member or second bondable member with a first nickel binder containing particles of one or both of nickel or a nickel alloy and an organic dispersion medium to form a coating layer, a drying step of making the coating layer dry to form a dried coating layer, a sticking layer forming step of coating one or both of a bonding surface of the bondable member not formed with the dried coating layer among the first bondable member and second bondable member or the surface of the dried coating layer with a second nickel binder containing particles of one or both of nickel or a nickel alloy and an organic dispersion medium to form a sticking layer, a laminate forming step of superposing the first bondable member and second bondable member through the dried coating layer and the sticking layer to form a laminate comprising the first bondable member and the second bondable member between which the dried coating layer and sticking layer are sandwiched, and a bonding layer forming step of heating and firing the laminate formed at the laminate forming step to form a bonding layer comprised of a sintered body of particles of one or both of nickel or a nickel alloy between the first bondable member and second bondable member, wherein in any cross-section in the bonding layer, a porosity of voids having a circle equivalent diameter of 1 $\mu$m or more is 30% or less, wherein, in any cross-section in the bonding layer, a porosity of voids having a circle equivalent diameter of 1 $\mu$m or more is 1% to 50%, wherein, as the particles of nickel or a nickel alloy in the nickel binder, nanoparticles (Pn) of a mean particle diameter of 15 nm to 150 nm measured by SEM observation and microparticles (Pm) of a mean particle diameter of 0.5 $\mu$m to 10 $\mu$m measured by SEM observation are copresent, and when a cross-sectional area of the nanoparticles (Pn) is Sn and a cross-sectional area of the microparticles (Pm) is Sm, the value of Sn/(Sn+Sm) is 0.2 to 0.8.

(11) The method of production of a conductive bonded assembly according to any one of (7) to (10), wherein the sticking layer is flattened by burying concavity and convexity on the surface of the dried coating layer.

Advantageous Effects of Invention

According to the present invention, it is possible to provide a conductive bonded assembly having excellent bonding strength and excellent electron migration characteristic and ion migration characteristic even if firing and sintering by heating under non-pressing conditions and, further, possible to provide a semiconductor device using the same.

Brief Description of Drawings

FIG. 1 is an explanatory view schematically showing the sintered state of Ni particles in the present invention.
FIG. 2 is an explanatory view of the process for production explaining the process for production of a conductive bonded assembly of an electronic component of the present invention.

FIG. 3 is an image of a cut surface obtained by observing the cut surface showing the Ni sintered bonding layer by an optical microscope for a test piece obtained in Example 5 of the present invention (dummy semiconductor device).

FIG. 4 is an X-ray fluoroscopic image obtained when observing a test piece obtained in Example 5 of the present invention (dummy semiconductor device) by X-ray fluoroscopic observation.

FIG. 5 is an X-ray fluoroscopic image obtained when observing a test piece obtained in Comparative Example 2 of the present invention (dummy semiconductor device) by X-ray fluoroscopic observation.

FIG. 6 is an image obtained by examining the cut surface of an Ni sintered bonding layer of a test piece obtained in Example 5 of the present invention (dummy semiconductor device) by a TEM to obtain an image of a cut surface, setting a threshold value so that voids are selected in accordance with the above-mentioned "method of measurement of porosity", and digitalizing the image. Description of Embodiments

The present invention will be explained in detail. Note that the embodiments introduced in this Description are just illustrations of embodiments of the present invention. The present invention was not limited to the embodiments explained in this Description.

Particles of one or both of nickel and a nickel alloy forming the sintered body of the bonding layer (in this Description, sometimes called the "Ni sintered bonding layer") (in this Description, sometimes called simply the "Ni particles") include nanoparticles (Pn) of a mean particle diameter of 15 nm to 150 nm measured by SEM observation (in this Description, sometimes called the Ni nanoparticles") and microparticles (Pm) of a mean particle diameter of 0.5 $\mu$m to 10 $\mu$m measured by SEM observation (in this Description, sometimes called "Ni microparticles") which are copresent. The Ni nanoparticles (Pn) are present so that the value (Sn/(Sn+Sm)) of the ratio of the cross-sectional area of the Ni nanoparticles (Pn) to the total of the cross-sectional area of the Ni nanoparticles (Pn) (Sn) and the Ni cross-sectional area of the microparticles (Pm) (Sm) becomes 0.2 to 0.8. At bonding surfaces between the first and second bondable members and Ni sintered bonding layer (meaning surfaces where bondable member and bonding layer face each other), the contact area of the bondable members with the Ni sintered bonding layer (area of parts where bondable member and Ni particles in the bonding layer actually contact) may be 90% or more of the bonding surfaces by observation by X-ray fluoroscopic image. Further, it is preferable that no non-contact part of a circle equivalent diameter of 1 mm or more in size be detected by observation by X-ray fluoroscopic image at the bonding surfaces between the first and second bondable members and the Ni sintered bonding layer.

The conductive bonded assembly according to the present invention is particularly effective for the case where one bondable member is a metal member and the other bondable member is a semiconductor chip comprised of silicon (Si) or silicon carbide (SiC) as a substrate on which a metal is vapor deposited.

Furthermore, the conductive bonded assembly according to the present invention is a conductive bonded assembly comprised of the first bondable member and the second bondable member bonded together using a nickel binder containing Ni particles and an organic dispersion medium produced by a coating layer forming step of coating a bonding surface of either one of the first and second bondable member with a first nickel binder to form a coating layer, a drying step of making the coating layer formed at the coating layer forming step dry to form a dried coating layer, a sticking layer forming step of coating at least one of the bonding surface of the other of the first and second bondable member or the surface of the dried coating layer with a second nickel binder to form a sticking layer, a laminate forming step of superposing the first bondable member and second bondable member through the dried coating layer formed at the drying step and the sticking layer formed at the sticking layer forming step to form a laminate comprising the first bondable member and the second bondable member between which the dried coating layer and sticking layer are sandwiched, and a bonding layer forming step of heating the laminate formed at the laminate forming step and firing the dried coating layer and bonding layer to form an Ni sintered bonding layer comprised of a sintered body of Ni particles between the first bondable member and second bondable member.

As the Ni particles in the nickel binder, Ni nanoparticles (Pn) of a mean particle diameter of 15 nm to 150 nm measured by SEM observation and Ni microparticles (Pm) of a mean particle diameter of 0.5 $\mu$m to 10 $\mu$m measured by SEM observation are copresent. Further, at this time, the Ni nanoparticles (Pn) are present so that the value (Sn/(Sn+Sm)) of the ratio of the cross-sectional area of the Ni nanoparticles (Pn) to the total of the cross-sectional area of the Ni nanoparticles (Pn) (Sn) and the cross-sectional area of the Ni microparticles (Pm) (Sm) becomes 0.2 to 0.8. Further, it is preferable that the sticking layer at least buries concavity and convexity on the surface of the dried coating layer formed at the drying step to flatten it.

In the laminate forming step, to make the thickness of the sticking layer thin and substantially uniform, it is also possible to "lightly press" the first bondable member and the second bondable member together. The sticking layer of the second nickel binder forming the laminate is for burying the concavity and convexity on the surface of the dried coating layer formed at the drying step to flatten it and is for securing adhesion between the surface of this dried coating layer and what is laminated on it, that is, between the first bondable member and the second bondable member. Further, this is for preventing positional deviation between the first bondable member and the second bondable member side at this laminate. It is fired at the next step of the bonding layer forming step while not yet dried, so it is sufficient to press it to make it thinner without heating and, at the time of firing the sticking layer, reduce the amount of organic dispersion medium or dispersant evaporating from this sticking layer and reduce the formation of voids derived from the sticking layer.

The first bondable member and the second bondable member to be bonded with each other through the conductive bonding layer have to be bonded with each other through the conductive bonding layer at an electronic component. For this reason, they are not particularly limited so long as they can withstand the temperature when using a nickel binder containing Ni particles and an organic dispersion medium and firing and sintering the Ni particles in this nickel binder to form the Ni sintered bonding layer. However, preferably, one bondable member (for example, the first bondable member) may for example be a cooling plate having Cu or a Cu alloy, Al or an Al alloy, or other conductive metal as a substrate, a heat sink, heat spreader, or other metal plate, circuit pattern or lead frame or other electrode plate, or conductive metal film on the surface of the insulating substrate, electrode terminals, conductive wire, or other metal member used in a semiconductor device. The other bondable member (for example, the second bondable member) may be a semiconductor chip comprised of a substrate (wafer) made of silicon (Si), silicon carbide (SiC), silicon germanium (SiGe), etc. on which resistors, capacitors, diodes, transistors, and other electronic circuits are integrated, having the function of a memory, microprocessor unit (MPU), sensor, solar cell, light emitting diode (LED), laser diode, converter, inverter, etc., and used for a semiconductor device.

The conductive bonded assembly according to the present invention can also be applied to a power semiconductor device where the metal member of the first bondable member is a circuit pattern or lead frame or other electrode plate and the second bondable member is a power semiconductor device comprised of a silicon (Si), silicon carbide (SiC), or other substrate (wafer) on which converters, inverters, or other electronic circuits are integrated since at the time of firing the Ni particles, it is possible to heat and sinter them under non-pressing conditions to form a Ni sintered bonding layer.

The Ni sintered bonding layer bonding the first bondable member and the second bondable member is formed by an Ni sintered body of Ni particles. The Ni sintered bonding layer formed by this Ni sintered body is preferably formed by purity 99 mass% or more pure Ni fine particles. Alternatively, it is preferably formed by Ni alloy fine particles containing carbon (C), oxygen (O), copper (Cu), gold (Au), aluminum (Al), or another metal besides nickel in a ratio of 1 mass% to 20 mass%, preferably 1 mass% to 10 mass%. Regarding the elements other than Ni, elements present in the Ni particles used at the time of formation of the Ni sintered bonding layer and elements diffusing and migrating from the first bondable member and/or the second bondable member side to be bonded together at the time of formation of the Ni sintered bonding layer are included.

The Ni sintered bonding layer preferably has a micron size or more porosity of 30% or less, more preferably 10% or less. If this micron size or more porosity exceeds 30%, unavoidably the contact area between the first and the second bondable members and the Ni sintered bonding layer will fall and the desired bonding strength will no longer be obtained. Further, for example, in the case of a power semiconductor device, this becomes a heat spot at the time of use. Frequent thermal impact occurs causing damage to the semiconductor chip and becoming a cause of reduced reliability. Furthermore, the micron size or more porosity of this Ni sintered bonding layer is preferably 10% or less for improving the heat dissipation of the bonding layer and extending its lifetime in power cycle tests or other reliability tests.

Further, the submicron size or less porosity of this Ni sintered bonding layer is 1% to 50%. If this is less than 1%, when forming an Ni sintered bonding layer using a nickel binder containing Ni particles and an organic dispersion medium, in particular, an Ni particle paste containing a dispersant or binder, the organic matter in this nickel binder remains in the Ni sintered bonding layer, in particular at the center part of the same, whereby sintering is obstructed or, further, the vaporized or heat decomposed organic components remain as bubbles and as a result the desired bonding strength may no longer be obtained. Further, if greater than 50%, due to the insufficient volume of the bonded parts of particles with other particles, the bonding strength may fall. The micron size or more porosity or the submicron size or less porosity can be controlled by the firing method, pressing conditions, firing temperature, or composition of the nickel binder.

Here, when finding the micron size or more porosity or the submicron size or less porosity of the Ni sintered bonding layer, there is the method of fabrication of an observed test piece for observation of the cut surface from the conductive bonded assembly and finding the porosity of the Ni sintered bonding layer from the image of the cut surface of this observed test piece, but in this case, the value of the porosity found will differ depending on the magnification at the time of acquiring the image of the cut surface.

In the present invention, the porosity of the Ni sintered bonding layer was found as follows:

Method of Measurement of Micron Size or More Porosity

First, the conductive bonded assembly is buried in a curable epoxy resin or other resin, the resin is made to cure, then the assembly is cut vertical to the stacking direction from the first bondable member through the Ni sintered bonding layer to the second bondable member to cut out a test piece of a size fitting on the stage of the stereo microscope from the cut surface of the conductive bonded assembly, in particular the cut surface of the Ni sintered bonding layer, and the cut surface of this test piece is polished to prepare an observed test piece for observation of the cut surface. (The cut surface is not particularly limited to a direction vertical to the stacking direction and may be any cross-section. However, in actual work, it is preferably cut in a direction vertical to the stacking direction.)

Next, the prepared observed test piece is set on the stage of the stereo microscope and the cut surface is observed under 200X to obtain an image of the cut surface.

The thus acquired image of a cut surface of the observed test piece is read into an image analysis tool (for example, ImageJ 1.47v; Wayne Rasband, public domain), the image is converted to grayscale by 8-bits, then the length of the scale bar in the image is measured and the length per pixel of the read image is recorded from the measured length of the scale bar.

After this, the range (1) required for calculation from the image of the cut surface is selected, the unnecessary parts are deleted, then a threshold value is set so that the voids are selected, the image is digitalized, the voids are judged, and the area (2) of the micron size or more voids is calculated.

Here, the "micron size or more voids" means voids of a circle equivalent diameter of 1 $\mu$m or more.

The "micron size or more porosity" referred to in the present invention is found as the ratio of the area (2) of micro size or more voids to the range (1) required for the above calculation [{(2)/(1)}×100: %].

Method of Measurement of Submicron Size or Less Porosity

First, the conductive bonded assembly is buried in a curable epoxy resin or other resin, the resin is made to cure, then the assembly is cut vertical to the stacking direction from the first bondable member through the Ni sintered bonding layer to the second bondable member to cut out a thin film test piece fitting on the stage of a transmission type electron microscope (TEM) from the cut surface of the conductive bonded assembly, in particular the cut surface of the Ni sintered bonding layer, to prepare an observed test piece for TEM observation. (The cut surface is not particularly limited to a direction vertical to the stacking direction and may be any cross-section. However, in actual work, it is preferably cut in a direction vertical to the stacking direction.)

Next, the prepared observed test piece is set on the stage of the TEM and the cut surface is observed by a field of 1000 nm or less x 1000 nm or less (for example, 670 nm x 790 nm) to obtain an image of the cut surface. The thus acquired image of a cut surface of the observed test piece is read into an image analysis tool (for example, ImageJ 1.47v; Wayne Rasband, public domain), the image is converted to grayscale by 8-bits, then the length of the scale bar in the image is measured and the length per pixel of the read image is recorded from the measured length of the scale bar. After this, the range (3) required for calculation from the image of the cut surface is selected, the unnecessary parts are deleted, then a threshold value is set so that the voids are selected, the image is digitalized, the voids are judged, and the area (4) of the submicron size or less voids is calculated.

Here, the "submicron size or less voids" means voids of a circle equivalent diameter of less than 1 $\mu$m.

The "submicron size or less porosity" referred to in the present invention is found as the ratio of the area (4) of submicron size or less voids to the range (3) required for the above calculation [{(4)/(3)}×100: %].

When something similar to the above magnification is obtained, a scan type electron microscope (SEM) may be used for observation.

Further, in the present invention, the contact area at the bonding surfaces between the first and second bondable members and the Ni sintered bonding layer is preferably, by observation by an X-ray fluoroscopic image, 90% or more of the bonding surface, more preferably 95% or more. Further, preferably no non-contact part of a size of a circle equivalent diameter of 1 mm or more by X-ray fluoroscopic image is detected at the bonding surfaces between the first and second bondable members and the Ni sintered bonding layer. If the contact area between the bondable members and the Ni sintered bonding layer is less than 90%, due to the insufficient bonding volume, the bonding strength may fall. Further, if there is a non-contact part of a size of a circle equivalent diameter of 1 mm or more at the bonding surfaces between the first and second bondable members and the Ni sintered bonding layer, a non-uniform bonded state will result, so heat dissipation will slow, thermal stress will also be applied, and the reliability may fall. Note that, the "bonding surface" means the area where a bondable member and the bonding layer face each other and includes not only the area where the particles in the bonding layer and the bondable member actually contact, but also the parts of the voids in the bonding layer.

The conductive bonded assembly according to the present invention is produced through the following process using a nickel binder containing Ni particles, an organic dispersion medium, and a dispersant. That is, the conductive bonded assembly is produced through a coating layer forming step of coating a bonding surface of either one of the first and second bondable members with a first nickel binder to form a coating layer, a drying step of making the coating layer dry to form a dried coating layer, a sticking layer forming step of coating at least one of a bonding surface of the other of the first and second bondable members or the surface of the dried coating layer with a second nickel binder to form a sticking layer, a laminate forming step of superposing the first bondable member and second bondable member through the dried coating layer formed at the drying step and the sticking layer formed at the sticking layer forming step to form a laminate comprised of the first bondable member and the second bondable member between which the dried coating layer and sticking layer are sandwiched, and a bonding layer forming step of heating the laminate without pressing to sinter the dried coating layer and bonding layer to form an Ni sintered bonding layer comprised of a sintered body of Ni particles between the first bondable member and the second bondable member.

The first nickel binder forming the coating layer and the second nickel binder forming the sticking layer are fired together and sintered to form the Ni sintered bonding layer, so as long as nickel binders which are fired resulting finally in the Ni particles becoming an Ni sintered body, they may be the same in composition as each other or may be different in composition. By making the compositions of the first nickel binder and the second nickel binder the same and using a single type of nickel binder, it is possible to make the preparation and handling of the nickel binder more efficient. Further, by considering the functions sought from the coating layer formed by the first nickel binder and the sticking layer formed by the second nickel binder and changing the compositions to more effectively realize these functions, it is also possible to further improve the bonding strength etc.

The amount of use of the first nickel binder when forming the coating layer at the coating layer forming step is determined in accordance with the thickness sought from the Ni sintered bonding layer formed at the bonding layer forming step. For example, from the viewpoint of reduction of size of the semiconductor device and reduction of the thermal resistance, it is sought to make the Ni sintered bonding layer relatively thin, so the amount of use of the first nickel binder is preferably reduced. Conversely, from the viewpoint of reduction of the thermal stress occurring due to the low coefficient of thermal expansion of the Ni sintered bonding layer, it is sought to make the Ni sintered bonding layer relatively thick, so the amount of use of the first nickel binder is preferably increased. Usually, it is made 0.002 $g/cm^2$ to 0.2 $g/cm^2$ in range.

Further, at the bonding layer forming step of heating the laminate without pressing and firing the dried coating layer and bonding layer so as to form an Ni sintered bonding layer between the first bondable member and second bondable member, the laminate is fired in a reducing atmosphere at 200°C to 400°C, preferably 250°C to 300°C in temperature to sinter the Ni particles present at the dried coating layer and binding layer. Here, the "reducing atmosphere" means an atmosphere enabling reduction of the Ni oxide film. Specifically, for example, it is preferably a hydrogen-containing inert gas atmosphere having hydrogen in a predetermined concentration. If considering safety, the hydrogen concentration must be made one of the explosive limit or less, so nitrogen gas, argon gas, etc. with a concentration of hydrogen of 1 vol% to 4 vol%, preferably 2 vol% to 3 vol%, may be illustrated.

If the sintering temperature is less than 200°C, due to the insufficient temperature, the problems may arise of the oxide film present on the surface of the nickel particles being not reduced by the hydrogen or of organic components impairing sintering easily remaining at the center part in particular. Conversely, if over 400°C, the thermal stress occurring at the cooling process after firing becomes larger and the bonding strength may fall and warping or separation may easily occur.

Note that, in the bonding layer forming step forming this Ni sintered bonding layer, when sintering the dried coating layer and sticking layer sandwiched between the first bondable member and the second bondable member, there is no need to press these first bondable member and second bondable member in the stacking direction, but from the viewpoint of manufacturing by the manufacturing equipment etc., the members may be pressed as necessary when they can be easily pressed. By pressing, the distance between particles becomes smaller, the contact area between the particles and other particles increases, the sinterability is improved, and, further, the filling rate of the Ni particles also becomes higher causing the voids to be reduced and the bonding strength and bonding reliability to be further improved.

The nickel binder for use as the first nickel binder and the second nickel binder is preferably an Ni particle slurry or Ni particle paste obtained by dispersing Ni particles in an organic dispersion medium using a dispersant and more preferably is an Ni particle paste containing Ni particles at a high concentration. Further, such Ni particle paste preferably contains Ni particles, an organic dispersion medium, dispersant, and binder.

The Ni particles for preparing the nickel binder may be produced by any method so long as causing sintering at 200 to 400°C in temperature at the time of firing the dried coating layer and sticking layer at the bonding layer forming step. For example, they may also be formed by the breakdown method of subdividing the nickel coarse particles by mechanical means (crushing, dispersion, etc.) or further by the buildup method of formation through the process of formation of nuclei and growth from ions or atoms of nickel. It is necessary that the Ni particles be strongly bonded at the sintering temperature, so preferably there are mean particle diameter 15 nm to 150 nm, preferably mean particle diameter 70 nm to 100 nm, Ni nanoparticles (Pn) measured by SEM observation present.

Further, to reduce the shrinkage due to sintering at the time of sintering at the bonding layer forming step and suppress the formation of voids and non-contact parts in the Ni sintered bonding layer formed, it is also effective to make mean particle diameter 0.5 μm to 10 μm, preferably mean particle diameter 0.5 μm to 2 μm Ni microparticles (Pm) measured by SEM observation copresent. By making these Ni nanoparticles (Pn) and Ni microparticles (Pm) copresent, Ni microparticles (Pm) become present like blocking particles. The shrinkage by sintering of the Ni nanoparticles (Pn) is halted around these Ni microparticles (Pm). As a result, the voids are finely divided and split. Due to this, micron size or more voids become difficult to form and a good Ni sintered bonding layer is formed. Further, when using, as Ni particles, Ni nanoparticles (Pn) of a mean particle diameter of 15 nm to 150 nm measured by SEM observation and Ni microparticles (Pm) of a mean particle diameter of 0.5 $\mu$m to 10 $\mu$m measured by SEM observation mixed together, Ni nanoparticles (Pn) is made present so that the value of the ratio (Sn/(Sn+Sm)) of the cross-sectional area of the Ni nanoparticles (Pn) to the total of the cross-sectional area of the Ni nanoparticles (Pn) (Sn) and Ni cross-sectional area of the microparticles (Pm) (Sm) becomes 0.2 to 0.8.

Here, if the mean particle diameter of the Ni nanoparticles in the nickel binder is less than 15 nm, aggregation becomes easy and handling becomes difficult. Further, the surface area increases, the required amount of dispersant also increases, the dispersant remains as organic matter even after firing, sintering is easily obstructed, and, further, large voids easily form along with shrinkage with sintering, and the bonding strength and bonding reliability may fall. Conversely, if the mean particle diameter of Ni nanoparticles exceeds 150 nm, low temperature firing at 400°C or less becomes difficult.

If the mean particle diameter of the Ni microparticles in the nickel binder is less than 0.5 $\mu$m, differentiation from the Ni nanoparticles becomes difficult, while conversely if over 10 $\mu$m, the viscosity of the nickel binder becomes higher and coating of the nickel binder may become difficult. Further, if the value of the ratio of the cross-sectional area of the Ni nanoparticles (Pn) (Sn/(Sn+Sm)) is outside the range of 0.2 to 0.8 in value, in any case, the voids or non-contact parts may increase and the effect of use of Ni nanoparticles and Ni microparticles mixed, that is, a more superior bonding strength and/or bonding reliability, can no longer be achieved. Note that, in the nickel binder, to establish presence so that the value of the ratio (Sn/(Sn+Sm)) of the cross-sectional area of the Ni nanoparticles (Pn) to the total of the cross-sectional area of the Ni nanoparticles (Pn) (Sn) and Ni cross-sectional area of the microparticles (Pm) (Sm) becomes 0.2 to 0.8, since the cross-sectional area ratio (Sn/(Sn+Sm)) generally matches with the weight ratio of these Ni nanoparticles (Pn) and Ni microparticles (Pm) in the nickel binder, it is sufficient that these Ni nanoparticles (Pn) and Ni microparticles (Pm) be present in a weight ratio of 0.4 to 0.8.

The dispersant for preparing the nickel binder plays the role of suppressing aggregation and the role of suppressing oxidation. It is preferably organic matter which breaks down or is consumed by the sintering temperature. Preferably, a dispersant comprised of a fatty acid or a dispersant comprising a fatty acid plus an aliphatic amine may be used. Among these, the fatty acid may be a saturated or unsaturated one and may be a straight chain or branched type. For example, propionic acid, butanoic acid, pentanoic acid, hexanoic acid, heptanoic acid, octanoic acid, or other $C_3$ to $C_8$ saturated fatty acid, butenoic acid (crotonic acid etc.), pentenoic acid, hexenoic acid, heptenoic acid, octenoic acid, sorbic acid (2,4-hexadienoic acid), dodecanoic acid, tetradecanoic acid, hexadecanoic acid, octadecanoic acid, oleic acid, etc. may be mentioned. The dispersant may include these fatty acids as single types alone or may include two types or more. On the other hand, the aliphatic amine may be a saturated or unsaturated one, may be any of a primary, secondary, or tertiary amine, and may be a straight chain or branched type. As such an aliphatic amine, for example, propylamine, butylamine, pentylamine, hexylamine, heptylamine, octylamine, or other alkylamine, allylamine, or other alkenylamine, dodecylamine, tetradecylamine, hexadecylamine, octadecylamine, oleylamine, etc. may be mentioned. The dispersant may include these fatty amines as single types alone or may include two types or more.

The organic dispersion medium for preparing the nickel binder may be one which vaporizes or is consumed until at least sintering of the Ni particles is not obstructed when firing the dried coating layer and sticking layer to cause the Ni particles to sinter and form the Ni sintered bonding layer in the bonding layer forming step. As such a dispersion medium, for example, dodecanol, octanol, oleyl alcohol, ethyleneglycol, triethyleneglycol, tetraethyleneglycol, terpineol, methanol, ethanol, propanol, or other alcohol-based solvents or hexane, toluene, or other lipophilic solvents or other organic dispersion media may be illustrated.

A nickel binder includes at least Ni particles and an organic dispersion medium. For example, when used as an Ni particle paste, the Ni particles are included in a ratio by mass% of 50 to 95 mass%, the organic solvent in 5 to 50 mass%, the binder in 5 mass% or less, and the dispersant in 1 mass% or less. Further, this nickel binder may further contain, in a range not impairing the effect of the present invention, additives in accordance with need etc. sought from the form etc. such as a defoamer, plasticizer, surfactant, thickener, or other third component in a range of 10 mass% or less, preferably a range of 5 mass% or less.

Method of Measurement of Mean Particle diameter of Ni Particles in Nickel Binder and Deviation Value of Same

The mean particle diameter of the Ni particles in the nickel binder and the deviation value of the same can be found from an SEM image of a measurement use sample obtained by preparing a measurement use sample by the following method and further using a scan type electron microscope (FE-SEM) (for example, S-4800 made by Hitachi High Technologies) to capture an image of the same by the following method.

(1) Acquisition of SEM Image

For the sample for measurement of the mean particle diameter of the Ni particles in the nickel binder and the standard deviation value, a sample for SEM observation was prepared by the so-called "dispersion method" and the obtained sample for SEM observation was observed by an SEM at 100,000X to obtain an SEM image. That is, about one teaspoon's worth of Ni particles to be added to the nickel binder was placed in a 10 ml screw tube, about 9 ml of ethanol was added, the mixture was ultrasonically washed for 5 minutes, then was allowed to sufficiently stand, then just the supernatant of the solution was recovered so as not to take the precipitate formed at the bottom of the screw tube. Next, this recovered supernatant was placed in a separate screw tube, ethanol was added to a total 9 ml, the mixture was ultrasonically washed, allowed to stand, and harvested for supernatant in the same way as the above repeatedly two times. After this, the recovered supernatant was dropped on a carbon support film and allowed to dry to prepare a sample for SEM observation.

The thus prepared sample for SEM observation was observed by an SEM by 100,000X in the case of Ni nanoparticles and was observed by an SEM by 1500X in the case of Ni microparticles to obtain respective SEM images.

(2) Calculation of Mean Particle diameter of Ni Particles and Standard Deviation Value

Next, the obtained SEM image was read into software able to process the image (for example, Microsoft® Office PowerPoint® etc.), the particles aligned at the surfacemost part were visually judged, the etched parts of the primary particles at the surfacemost part were traced, the particles were filled in one at a time, and the reference scale bar was added by a straight line. Further, the above image was exported to the tif format and read into an image analysis tool (for example, ImageJ 1.47V(Wayne Rasband, National Institutes of Health, USA. ImageJ is in the public domain.)) Further, the read image with the scale bar was converted to grayscale (8 bits), then the length of the scale bar in the image was measured and the length per pixel of the read image was recorded from the measured length of the scale bar. Further, a part other than the scale bar was selected to obtain an image of only the particles and the threshold value was determined for digitalizing the particle image. At that time, the parts where the particles were superposed (neck parts after sintering) were geometrically processed (Watershed processing) for digitalization separated from each other.

In the thus obtained digitalized image, the particles were already differentiated, so the Feret diameter (longest distance between two points in particle) was read and the arithmetic mean Feret diameter was calculated. The Feret diameter at this time corresponds to the diameter in the case where the particles are true spheres.

In the above way, any viewing angle 1270 nm$\times$950 nm SEM image (100,000X) is selected, the arithmetic mean Feret diameter was calculated for about 70 to 100 Ni particles in the SEM image and used as the mean particle diameter, then the standard deviation value was calculated from all of the Feret diameters.

Note that, the Ni particles contained in the nickel binder have a sintering temperature of 200 to 400°C, so even inside the Ni sintered bonding layer after sintering, sintering occurs at the mutually contacting parts leading to the formation of so-called "neck parts" which remain in the bonded state. The particle diameter of the Ni particles in the nickel binder is substantially maintained to a measurable extent even in the sintered Ni sintered bonding layer.

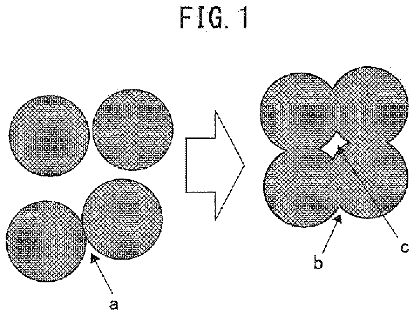

That is, in general, in the sintering process of metal particles, (A) the particles are brought into acute angle contact, (B) the neck parts are formed and grow and open pores are formed, (C) the neck parts and grain boundaries are enlarged and the open pores are connected (networked), and (D) the pores are cut to make them independent and eliminate them in that order. For example, with Ag nanoparticles or Au nanoparticles, these processes easily proceed. Finally, like in (D), almost all continuous voids close and the voids are eliminated (for example, see "Sintered Material Engineering", Tsuneo Ishida, published by Morikita Publishing, page 78). As opposed to this, in the present invention, metal particles comprised of Ni particles are used and the sintering temperature is 200 to 400°C, so as shown in FIG. 1, the sintering stops at the extent from (A) (figure at left side of arrow mark) the acute angle contact "a" due to aggregation of Ni particles to (B) (figure at right side of arrow mark) growth and formation of the neck parts "b", pores (continuous pores "c") remain, and the particle diameter of Ni particles in the nickel binder is substantially maintained even in the Ni sintered bonding layer after sintering.

That is, the submicron size or less voids are the pores, that is, voids between Ni particles and other Ni particles (continuous pores). Due to the submicron size or less voids, when using a nickel binder containing Ni particles and organic dispersion medium, in particular an Ni particle paste containing a dispersant, binder, and additive, to form an Ni sintered bonding layer, escape holes for the gas formed by breakdown of the organic components are secured.

In the case of so-called powder sintering, for densification or grain growth, generally firing while pressing or high temperature firing at 500°C or more is performed. On the other hand, in the bonding layer of the present invention, to prevent the device from being destroyed due to heat and, further, to reduce the thermal stress occurring in the cooling process at the time of bonding, the firing is often performed at a low temperature of 300°C or less. Furthermore, the nanoparticles used in the above binder contain a large amount of organic matter mainly comprised of the dispersant. If the organic matter is not removed, the sintering is hindered and the bonding strength falls or carbon remains potentially

EP 3 217 424 B1

causing a drop in the heat dissipation. That is, submicron size or less voids are believed to perform an important role as a route for removal of organic matter at the time of firing at a low temperature of 300°C or less.

Method of Production of Conductive Bonded Assembly

Here, the method of production of the conductive bonded assembly will be explained in further detail using the drawings.

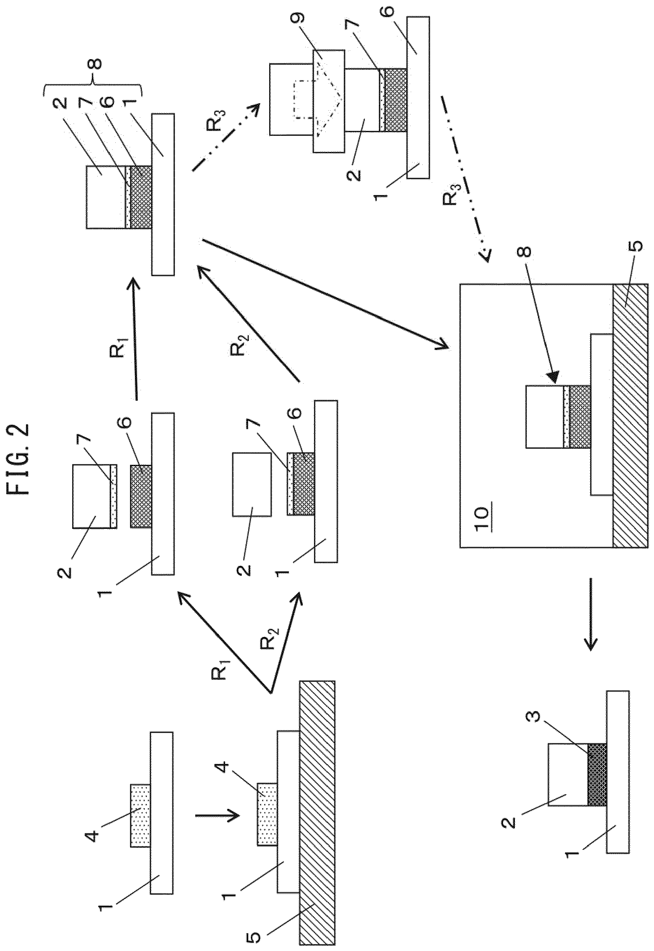

In FIG. 2, first, the surface of the first bondable member 1 is coated by the screen printing method, stencil mask method, or other coating means with the first nickel binder to form the coating layer 4 (coating layer forming step). Next, the coating layer 4 formed on the surface of the first bondable member 1 is heated by stage heating, heating using a reflow furnace or firing furnace or other heating means 5, the organic dispersion medium mainly in this coating layer 4 is removed, and the dried coating layer 6 is obtained (drying step).

The surface of the dried coating layer 6 formed on the surface of the first bondable member 1 in this way and/or the surface of the second bondable member 2 are coated with the second nickel binder in accordance with the route R1 or R2 in FIG. 2 to form the sticking layer 7 (sticking layer forming step), next the first bondable member 1 and the second bondable member 2 are superposed through the dried coating layer 6 formed by the drying step and the sticking layer 7 formed in the sticking layer forming step whereby a laminate 8 comprised of the first bondable member 1 and the second bondable member 2 between which the dried coating layer 6 and the sticking layer 7 are sandwiched is formed (laminate forming step).

The thus formed laminate 8 is set as is inside a firing apparatus 10. Inside this firing apparatus 10, the laminate 8 is heated in a reducing atmosphere by stage heating or other heating means 5 to 250°C to 400°C whereby the dried coating layer 6 and the sticking layer 7 inside the laminate 8 are fired. Due to this, the Ni fine particles in the dried coating layer 6 and sticking layer 7 are both sintered whereby a sintered bonding layer 3 is formed. Due to this sintered bonding layer 3, the first and second bondable members are bonded with each other, whereby a conductive bonded assembly is formed (laminate forming step). Here, the "reducing atmosphere" means an atmosphere in which the oxide film of Ni can be reduced. Specifically, for example, it is preferably a hydrogen-containing inert gas atmosphere containing hydrogen in a predetermined concentration. If considering safety, the concentration of hydrogen has to be made less than the explosive limit, so nitrogen gas, argon gas, etc. with a hydrogen concentration of 1 vol% to 4 vol%, preferably 2 vol% to 3 vol%, may be illustrated.

Further, for example, when the viscosity of the nickel binder used at the sticking layer is high or the surface roughness of the dried coating layer is large or otherwise when the contact between the sticking layer and dried coating layer is not made sufficient with just the inherent weight of the first or the second bondable member or when the sticking layer is coated thicker than necessary, the laminate 8 formed in the laminate forming step is lightly pressed if necessary in accordance with the route R3 of the two-dot chain arrows in the figure by a bonder, heavy stone, or other pressing means 9 (pressing before firing), is adjusted to a uniform, thin thickness (route of two-dot chain line in figure), then is set inside the firing apparatus 10. Inside this firing apparatus 10, in the same way as above, the dried coating layer 6 and the sticking layer 7 are fired, the sintered bonding layer 3 is formed, and the first and the second bondable members are bonded with each other whereby the conductive bonded assembly is formed (laminate forming step).

Examples

Examples 1 to 11

As the first bondable member, a dummy electrode plate (metal member) obtained by electroless plating a spotless copper substrate of a thickness 1 mm and size 15 mm×15 mm with nickel and gold to give a thickness of the nickel plating layer of 3 to 5 μm, a thickness of the gold plating layer of 0.1 μm, and a surfacemost part of the gold plating layer was used.

Further, as the second bondable member, a dummy semiconductor device (semiconductor chip) obtained by forming on one surface of an Si chip with a thickness of 0.45 mm and size of 6.0 mmx6.0 mm (or Si chip of thickness of 0.45 mm and size of 2.0 mm×2.0 mm) a sputtered film of Ti: 150 nm/Ni: 300 nm/Au: 50 nm and having a surfacemost part of a gold sputtered film was used.

Further, for the nickel binder, the following prepared Ni particle paste was used.
As the Ni particles, a mixture of Ni particles obtained by mixing Ni nanoparticles (Pn: product provided by Nippon Steel & Sumikin Chemical) modified by octanoic acid (dispersant) and having a mean particle diameter measured by SEM observation of 89 nm (standard deviation value SD: 18) or 78 nm (standard deviation value SD: 7) and Ni microparticles (Pm: product made by Kanto Chemical: nickel powder) having a mean particle diameter measured by SEM observation of 10 μm (standard deviation value SD: 2) or Ni microparticles (Pm: product made by Sigma Aldrich: nickel powder) having a mean particle diameter measured by SEM observation of 1.8 μm (standard deviation value SD: 0.4) in a cross-sectional area ratio (Sn/(Sn+Sm)) of Ni nanoparticles (Pn) and Ni microparticles (Pm) shown in Table 1 was used. Further, as the organic dispersion medium, a mixed organic solvent comprised of terpineol and tetradecane mixed in a weight ratio of 4.5:1 was used. As the binder, an acetal-based resin was used. These Ni particle mixture, mixed organic solvent, and binder were mixed in a weight ratio of 89:10.5:0.5 to prepare an Ni particle paste.

The thus prepared Ni particle paste was printed on one surface of a previously prepared electrode plate (first bondable member:metal member) using a thickness 100 $\mu$m stencil having a 6 mm×6 mm open part to prepare an electrode plate with a coating layer used for preparing a test piece for observation of the cut surface and observation by X-ray fluoroscopy (coating layer forming step). Further, it was printed using a 100 $\mu$m stencil having a 2 mm×2 mm open part to prepare an electrode plate with a coating layer used for preparing a test piece for measurement of the bonding strength (coating layer forming step).

Next, an electrode plate with a coating layer prepared for observation of the cut surface and for observation by X-ray fluoroscopy or for measurement of the bonding strength was heated using a reflow furnace (RSS-450-110, made by Uni Temp GmbH) in a 3%H2+97%N2 reducing atmosphere at a set temperature of 100°C×10 minutes to make the coating layer of the coated member dry and obtain an electrode plate with a dried coating layer having a dried coating layer on its surface (drying step).

Further, the previously prepared semiconductor device (second bondable member: semiconductor chip) was coated using a spatula and squeegee at the back of the chip (surface with metal sputtered film) with a previously prepared Ni particle paste to form a semiconductor device with a coating layer having a sticking layer (sticking layer forming step).

The thus prepared semiconductor device with a sticking layer and a previously prepared electrode plate with a dried coating layer were pressed using a flip chip bonder (Sony, Cellular Flip Chip Bonder, MCP-F100) at ordinary temperature (25°C) at 5 MPa for 10 sec while superposing the semiconductor device with a sticking layer on the electrode plate with a dried coating layer so that the sticking layer contacts the dried coating layer (pressing step before firing).

The thus mutually superposed semiconductor device with a sticking layer and electrode plate with a dried coating layer were fired using the reflow furnace in a 3%H2+97%N2 reducing atmosphere under conditions of a bonding temperature of 355°C and holding time of 60 minutes to cause the Ni particles in the dried coating layer and sticking layer to sinter and obtain an Ni sintered bonding layer comprised of an Ni sintered body and obtain a dummy semiconductor device (test piece: conductive bonded assembly) of each of Examples 1 to 11 comprised of a semiconductor device and electrode plate bonded by this Ni sintered bonding layer.

Comparative Examples 1 to 4

An Ni particle paste prepared by a method similar to the case of the above examples and having a cross-sectional ratio (Sn/(Sn+Sm)) of the Ni nanoparticles (Pn) and Ni microparticles (Pm) shown in Table 1 was printed on a single surface of a dummy electrode plate the same as the case of the above examples (first bondable member: metal member) using a thickness 100 $\mu$m stencil having an opening part of 6 mm×6 mm to prepare an electrode plate with a coating layer used for fabrication of a test piece for observation of a cut surface and for observation by X-ray fluoroscopy and further was printed using a thickness 100 $\mu$m stencil having an opening part of 2 mm×2 mm to prepare an electrode plate with a coating layer used for fabrication of a test piece for measurement of the bonding strength.

On the thus prepared electrode plate with a coating layer, a dummy semiconductor device used in each of the above examples was superposed so that the back of the chip of the semiconductor device contacted the coating layer then a 9.8 g heavy stone was placed on them to press them. In the same way as the case of each example, a reflow furnace was used to fire the assembly in a 3%H2+97%N2 reducing atmosphere under conditions of a bonding temperature of 300°C and a holding time of 60 minutes, cause the Ni particles in the coating layer to sinter to obtain an Ni sintered bonding layer comprised of an Ni sintered body, and thereby obtain a dummy semiconductor device comprised of a semiconductor device and an electrode plate bonded by this Ni sintered bonding layer of Comparative Examples 1 to 4 (test piece: conductive bonded assembly).

Measurement of Porosity, Bonding Surface Area, and 1 mm or more Non-Contact Part

Each test piece obtained by the above examples and comparative examples (dummy semiconductor device) was measured for porosity using a test piece (dummy semiconductor device) prepared for observation of the cut surfaces in accordance with the above-mentioned "method of measurement of porosity" and further was measured for bonding surface area and 1 mm or more non-contact parts using a test piece prepared for observation by X-ray fluoroscopy in accordance with the following "method of measurement of bonded state".

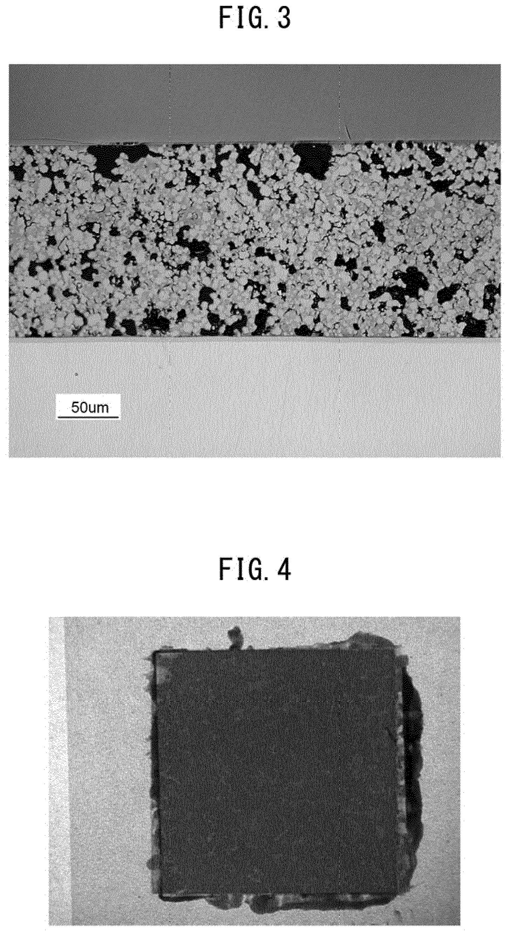

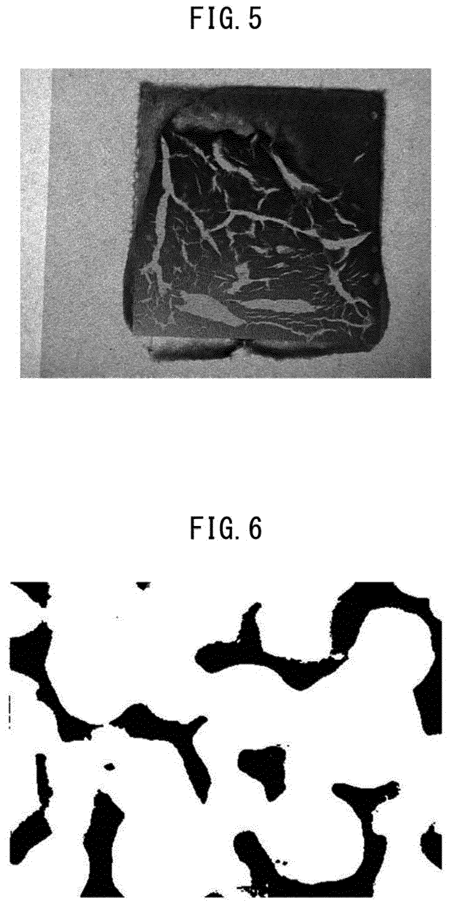

An image of the cut surface showing the Ni sintered bonding layer of the test piece of Example 5 (dummy semiconductor device) obtained in the above measurement of porosity and measurement of the bonded state is shown in FIG. 3, further, an X-ray fluoroscopic image of the test piece of Example 5 (dummy semiconductor device) is shown in FIG. 4, and, further, an X-ray fluoroscopic image of the test piece of Comparative Example 2 (dummy semiconductor device) is shown in FIG. 5.

Method of Measurement of Bonded State

Each test piece obtained in the examples and comparative examples was observed by X-ray fluoroscopy using a Microfocus X-Ray (Sub-Micron System, XT6600 made by Dage) to obtain an X-ray fluoroscopic image.
The obtained X-ray fluoroscopic image was read into an image analysis tool (ImageJ 1.47v; Wayne Rasband, public domain), the image was converted to grayscale by 8-bits, then the length per pixel of the read image was recorded from the length of one side of the known chip.
After that, the tip part (6 mm$\times$6 mm) was cut off, the rest of the parts was discarded, then the image was inverted black/white so that the non-contact parts became black. The threshold value was set so that the non-contact parts were selected, the image was digitalized, the non-contact parts were judged using the "Analyze Particles" function, then the area ratio (%) of the non-contact parts to the tip part (6 mm$\times$6 mm) was exported. If subtracting the area ratio% of the non-contact parts from 100%, the bonding surface area% is obtained.
Further, using the "Analyze Particles" function, simultaneously, the Feret diameter of each non-contact part was also exported. The obtained Feret diameter was read into Excel and the "Analysis Tool>Histogram" function of Excel was used to classify the Feret diameter by each 0.1 mm and calculate the frequency and cumulative %. Whether or not there are 1 mm or more voids was judged by whether the frequency of the Feret diameters classified as 1 mm or more was 0 or not.

Measurement of Initial Bonding Strength and Bonding Reliability

The initial bonding strength of each test piece prepared in the examples and comparative examples (dummy semiconductor devices) was found by using a bond tester (Universal Type Bond Tester made by Dage: Series 4000) to measure the shear strength of the Ni sintered bonding layer by a die shear mode. Note that, when measuring the initial bonding strength, three to four samples were prepared for each condition and the mean value was calculated.
Further, the bonding reliability was found by using a vapor phase type thermal shock analyzer (TSA-72ES-W made by ESPEC) to run a thermal cycle test repeating a thermal cycle for 1000 cycles of cooling at -40°C for 30 minutes and heating at 250°C for 30 minutes as one cycle and measuring the shear strength of the Ni sintered bonding layer after the test by the die shear mode. Alternatively, a test piece prescribed in JEITA ED-4701/600 was prepared, then a power cycle test was performed so that $\Delta Tj=80°C$ and the number of tests until the cathode and anode short circuited was found.

Evaluation of Measurement Results

The micron size or more porosity was evaluated by the criteria of "Excellent" if 15% or less, "Very good" if over 15% to 25%, "Good" if over 25% to 30%, and "Poor" if over 30%. Further, the submicron size or less porosity was evaluated by the criteria of "Good" if 1% to 50% and "Poor" if less than 1% or over 50%.
Further, the contact area was evaluated as "Very good" if 95% or more, "Good" if 90% to less than 95%, and "Poor" if less than 90%. Further, a 1 mm or more non-contact part was evaluated as "Good" if not included and "Poor" if included.
Furthermore, the initial bonding strength was evaluated as "Good" if 2 kgf/mm$^2$ or more, "Fair" if 1 kgf/mm$^2$ to less than 2 kgf/mm$^2$, and "Poor" if less than 1 kgf/mm$^2$. The bonding reliability was evaluated as "Good" if the value of the bonding strength after the reliability test/initial bonding strength was 0.8 or more, as "Fair" if the value of the bonding strength after the reliability test/initial bonding strength was 0.5 to less than 0.8, and as "Poor" if the value of the bonding strength after the reliability test/initial bonding strength was less than 0.5. Further, it was evaluated as "Very good" if the number of tests up to short-circuiting was $10^5$ or more and as "Good" if the number is less than $10^5$.
Further, the overall evaluation was "Very good" if both the initial bonding strength and bonding reliability were "Good", was "Good" if the initial bonding strength and bonding reliability were not "Poor", was "Fair" if either the initial bonding strength or bonding reliability was "Poor", but close to "Fair", and was "Poor" if both the initial bonding strength and bonding reliability were "Poor".
The above results of evaluation are shown in Table 1.
As clear from the results shown in Table 1, the test pieces obtained by the examples of the present invention (dummy semiconductor devices) were all better than the comparative examples in overall evaluation. In particular, in Examples 3 to 6 and 8 to 14, none of the porosity, bonding surface area, 1 mm or more non-contact parts, initial bonding strength, and bonding reliability was evaluated as "Poor". Even in the case of firing and sintering by heating under non-pressing conditions, it was learned that there were excellent initial bonding strength and bonding reliability. Furthermore, in Examples 9 to 11, the micron size or more voids was 15% or less and a good result was shown in evaluation of the bonding reliability by a power cycle reliability test.

Further, the failure model of electron migration is expressed by the following formula (1) (see RENESAS, Rev. 1.00 2006.06.12 1-1. RJJ27L0001-0100.1). Further, the activation energy of nickel (Ni) (281 kJ/mol: measurement temperature 1143 to 1524°C) is clearly higher than the activation energy of silver (Ag) (189 kJ/mol: measurement temperature 913 to 1228°C) and the activation energy of copper (Cu) (211 kJ/mol: measurement temperature 971 to 1334°C), so, further, if focusing on the measurement temperature, in the case of silver (Ag) or copper (Cu), the temperature is lower than the case of nickel (Ni) and the phenomenon of electron migration is expected to also occur at a lower temperature than the case of nickel (Ni), so in a conductive bonded assembly using the Ni sintered bonding layer of the present invention, it is believed that clearly the electron migration characteristic is better compared with the case of using a sintered bonding layer of silver (Ag) or copper (Cu).

$$MTTF = A \times J^{-n} \times e^{Ea/kT} \quad\ldots\ldots(1)$$

where, MTTF is the mean time to failure (h), A is a constant determined by the structure and material of the interconnects, "n" is a constant, Ea is the activation energy (eV), "k" is the Boltzmann's constant, and, further, T is the absolute temperature (K) of the interconnect part.

Further, an Ni sintered body test piece of a size of 6 mm square and a thickness of 100 $\mu$m was fabricated, then a vapor phase type thermal shock analyzer (TSA-72ES-W made by ESPEC) was used to run a thermal cycle test repeating a thermal cycle for 700 cycles of cooling at -40°C for 30 minutes and heating at 250°C for 30 minutes as one cycle and investigate the change in weight of the test piece before and after a test. The ratio of the weight after the test to the weight before the test was 1.0. If the sintered body oxidizes, the weight increases, so it is believed that the Ni sintered body is a material resistant to progression of oxidation.

Table 1

| | | Porosity | | Nickel binder (Ni sintered bonding layer) | | | Bonding area (%) | 1 mm or more non-bonded parts | Initial bonding strength (kgf/mm$^2$) | Bonding reliability | | Overall evaluation |
|---|---|---|---|---|---|---|---|---|---|---|---|---|
| | | Micron size or more | Submicron size or less | Mean particle diameter of Pn (nm) | Mean particle diameter of Pm (μm) | Cross-sectional area ratio of Pn (Sn/(Sn+Sm)) | | | | Thermal cycle test | Power cycle test | |
| Ex. | 1 | Good | Good | 89 | 10 | 1.0 | Good | Poor | Fair | Poor | - | Fair |
| | 2 | Good | Good | Ditto (") | " | 0.8 | Good | Poor | Fair | Poor | - | Fair |
| | 3 | Good | Good | " | " | 0.7 | Very good | Good | Good | Fair | - | Good |
| | 4 | Good | Good | " | " | 0.6 | Very good | Good | Good | Good | - | Very good |
| | 5 | Good | Good | " | " | 0.5 | Very good | Good | Good | Good | Good | Very good |
| | 6 | Good | Good | " | " | 0.4 | Very good | Good | Fair | Fair | - | Good |
| | 7 | Good | Good | 89 | 1.8 | 0.8 | Good | Poor | Fair | Poor | - | Fair |
| | 8 | Good | Good | " | " | 0.7 | Very good | Good | Good | Fair | - | Good |
| | 9 | Very good | Good | " | " | 0.6 | Very good | Good | Good | Good | - | Very good |
| | 10 | Very good | Good | " | " | 0.5 | Very good | Good | Good | Good | - | Very good |
| | 11 | Very good | Good | 78 | 1.8 | 0.3 | Very good | Good | Good | Good | Very good | Very good |
| | 12 | Good | Good | 78 | 1.8 | 0.2 | Good | Good | Fair | Fair | - | Fair |
| | 13 | Good | Good | 78 | 10 | 0.5 | Very good | Good | Good | Good | - | Very good |
| | 14 | Good | Good | 78 | 10 | 0.4 | Very good | Good | Good | Good | - | Very good |

EP 3 217 424 B1

(continued)

| | | Porosity | | Nickel binder (Ni sintered bonding layer) | | | Bonding area (%) | 1 mm or more non-bonded parts | Initial bonding strength (kgf/mm²) | Bonding reliability | | Overall evaluation |
|---|---|---|---|---|---|---|---|---|---|---|---|---|
| | | Micron size or more | Submicron size or less | Mean particle diameter of Pn (nm) | Mean particle diameter of Pm (μm) | Cross-sectional area ratio of Pn (Sn/(Sn+Sm)) | | | | Thermal cycle test | Power cycle test | |
| Comp. ex. | 1 | Poor | Good | 89 | 10 | 0.4 | Poor | Poor | Poor | Poor | - | Poor |
| | 2 | Poor | Good | " | " | 0.5 | Poor | Poor | Poor | Poor | - | Poor |
| | 3 | Poor | Good | " | " | 0.6 | Poor | Poor | Poor | Poor | - | Poor |
| | 4 | Poor | Good | " | " | 1.0 | Poor | Poor | Poor | Poor | - | Poor |

(Note) Pn: Ni nanoparticles, Pm: Ni microparticles, Sn: cross-sectional area of Pn, Sm: cross-sectional area of Pm

Industrial Applicability

The present invention can be utilized for a semiconductor device or other bondable member. In particular, it can be utilized for bonding with an electrode material on an Si or SiC substrate.

Reference Signs List

a. acute angle contact of particles
b. neck part
c. pores (continuous pores)
R1. case of forming sticking layer on surface of dried coating layer of first bondable member
R2. case of forming sticking layer on surface of second bondable member
R3. case of pressing laminate
1. first bondable member
2. second bondable member
3. Ni sintered bonding layer
4. coating layer
5. heating means
6. dried coating layer
7. sticking layer
8. laminate
9. pressing means

**Claims**

1. A conductive bonded assembly of an electronic component having a first bondable member, a second bondable member, and a conductive bonding layer positioned between the first bondable member and the second bondable member and bonding the two bondable members,
   in which conductive bonded assembly of an electronic component, said bonding layer is a sintered body of particles of one or both of nickel or a nickel alloy, and, in any cross-section in said bonding layer, a porosity of voids having a circle equivalent diameter of 1 $\mu$m or more is 30% or less, and a porosity of voids having a circle equivalent diameter of less than 1 $\mu$m is 1% to 50%,
   wherein as the particles of nickel or a nickel alloy forming said bonding layer, nanoparticles (Pn) of a mean particle diameter of 15 nm to 150 nm measured by SEM observation and microparticles (Pm) of a mean particle diameter of 0.5 $\mu$m to 10 $\mu$m measured by SEM observation are copresent, and when a cross-sectional area of the nanoparticles (Pn) is Sn and a cross-sectional area of the microparticles (Pm) is Sm, the value of Sn/(Sn+Sm) is 0.2 to 0.8.

2. The conductive bonded assembly of an electronic component according to claim 1, wherein at a bonding surface of said first bondable member or second bondable member with said bonding layer, a contact area of said first bondable member or second bondable member with said bonding layer is 90% or more of the bonding surface by observation by X-ray fluoroscopic image.

3. The conductive bonded assembly of an electronic component according to claim 1 or 2, wherein at a bonding surface of said first bondable member or second bondable member with said bonding layer, there is not a non-contact part of a size of a circle equivalent diameter of 1 mm or more by observation by X-ray fluoroscopic image.

4. A semiconductor device provided with a conductive bonded assembly according to any one of claims 1 to 3, wherein said first bondable member is a metal member and, further, said second bondable member is a semiconductor chip having silicon or silicon carbide as a substrate.

5. A method of production of a conductive bonded assembly of an electronic component according to any one of claims 1 to 3, having a first bondable member, a second bondable member, and a conductive bonding layer positioned between the first bondable member and the second bondable member and bonding the two bondable members through bonding surfaces, said method of production of a conductive bonded assembly of an electronic component comprising:

a coating layer forming step of coating a bonding surface of either one of said first bondable member or second bondable member with a first nickel binder containing particles of one or both of nickel or a nickel alloy and an organic dispersion medium to form a coating layer,

a drying step of making said coating layer dry to form a dried coating layer,

a sticking layer forming step of coating one or both of a bonding surface of the bondable member not formed with the dried coating layer among said first bondable member and second bondable member or the surface of said dried coating layer with a second nickel binder containing particles of one or both of nickel or a nickel alloy and an organic dispersion medium to form a sticking layer,

a laminate forming step of superposing said first bondable member and second bondable member through said dried coating layer and said sticking layer to form a laminate comprising the first bondable member and the second bondable member between which said dried coating layer and sticking layer are sandwiched, and

a bonding layer forming step of heating and firing the laminate formed at said laminate forming step to form a bonding layer comprised of a sintered body of particles of one or both of nickel or a nickel alloy between said first bondable member and second bondable member,

wherein in any cross-section in said bonding layer, a porosity of voids having a circle equivalent diameter of 1 $\mu$m or more is 30% or less,

wherein, in any cross-section in said bonding layer, a porosity of voids having a circle equivalent diameter of less than 1 $\mu$m is 1% to 50%,

wherein, as the particles of nickel or a nickel alloy in said nickel binder, nanoparticles (Pn) of a mean particle diameter of 15 nm to 150 nm measured by SEM observation and microparticles (Pm) of a mean particle diameter of 0.5 $\mu$m to 10 $\mu$m measured by SEM observation are copresent, and when a cross-sectional area of the nanoparticles (Pn) is Sn and a cross-sectional area of the microparticles (Pm) is Sm, the value of Sn/(Sn+Sm) is 0.2 to 0.8.

**6.** The method of production of a conductive bonded assembly according to claim 5, wherein said sticking layer is flattened by burying concavity and convexity on the surface of said dried coating layer.

## Patentansprüche

**1.** Leitfähige verbundene Anordnung einer elektronischen Komponente, die ein erstes verbindbares Element, ein zweites verbindbares Element und eine leitfähige Verbindungsschicht aufweist, die zwischen dem ersten verbindbaren Element und dem zweiten verbindbaren Element angeordnet ist, und die beiden verbindbaren Elemente verbindet,

wobei in der leitfähigen verbundenen Anordnung einer elektronischen Komponente die Verbindungsschicht ein gesinterter Körper aus Partikeln aus einem oder aus beiden von Nickel oder einer Nickellegierung ist, und in einem beliebigen Querschnitt in der Verbindungsschicht eine Porosität von Hohlräumen, die einen kreisäquivalenten Durchmesser von 1 $\mu$m oder mehr haben, 30% oder weniger beträgt, und eine Porosität von Hohlräumen, die einen kreisäquivalenten Durchmesser von weniger als 1 $\mu$m haben, 1% bis 50 % beträgt,

wobei, als die Partikel aus Nickel oder einer Nickellegierung, die die Verbindungsschicht bilden, Nanopartikel (Pn) mit einem mittleren Partikeldurchmesser von 15 nm bis 150 nm gemessen durch REM-Beobachtung und Mikropartikel (Pm) mit einem mittleren Partikeldurchmesser von 0,5 $\mu$m bis 10 $\mu$m gemessen durch REM-Beobachtung miteinander vorhanden sind, und wenn eine Querschnittsfläche der Nanopartikel (Pn) Sn ist und eine Querschnittsfläche der Mikropartikel (Pm) Sm ist, der Wert von Sn/(Sn+Sm) 0,2 bis 0,8 beträgt.

**2.** Leitfähige verbundene Anordnung einer elektronischen Komponente nach Anspruch 1, wobei an einer Verbindungsfläche des ersten verbindbaren Elements oder des zweiten verbindbaren Elements mit der Verbindungsschicht eine Kontaktfläche des ersten verbindbaren Elements oder des zweiten verbindbaren Elements mit der Verbindungsfläche 90 % oder mehr der Verbindungsfläche gemäß einer Beobachtung durch ein Röntgenfluoroskopiesbild beträgt.

**3.** Leitfähige verbundene Anordnung einer elektronischen Komponente nach Anspruch 1 oder 2, wobei an einer Verbindungsfläche des ersten verbindbaren Elements oder des zweiten verbindbaren Elements mit der Verbindungsschicht kein Nicht-Kontaktteil in einer Größe eines kreisäquivalenten Durchmessers von 1 mm oder mehr gemäß einer Beobachtung durch ein Röntgenfluoroskopiesbild vorliegt.

**4.** Halbleiterbauelement, das mit einer leitfähigen verbundenen Anordnung nach einem der Ansprüche 1 bis 3 versehen ist, wobei das erste verbindbare Element ein Metallelement ist, und weiterhin das zweite verbindbare Element ein Halbleiterchip ist, der Silizium oder Siliciumcarbid als Substrat hat.

**5.** Verfahren zum Herstellen einer leitfähigen verbundenen Anordnung einer elektronischen Komponente nach einem der Ansprüche 1 bis 3, die ein erstes verbindbares Element, ein zweites verbindbares Element und eine leitfähige Verbindungsschicht aufweist, die zwischen dem ersten verbindbaren Element und dem zweiten verbindbaren Element angeordnet ist, und die zwei verbindbaren Elemente über Verbindungsflächen verbindet, wobei das Herstellungsverfahren einer leitfähigen verbundenen Anordnung einer elektronischen Komponente aufweist:

einen Schritt zum Ausbilden einer Beschichtungsschicht, um eine Verbindungsfläche von entweder dem ersten verbindbaren Element oder dem zweiten verbindbaren Element mit einem ersten Nickelbinder, der Partikel aus Nickel und/oder einer Nickellegierung enthält, und einem organischen Dispersionsmedium zu beschichten, um eine Beschichtungsschicht zu bilden,
einen Trocknungsschritt, um die Beschichtungsschicht zu trocknen, um eine getrocknete Beschichtungsschicht auszubilden,
einen Schritt zum Ausbilden einer Klebeschicht, um eine Verbindungsfläche des verbindbaren Elements, das nicht mit der getrockneten Beschichtungsschicht ausgebildet ist, aus dem ersten verbindbaren Element und dem zweiten verbindbaren Element und/oder die Oberfläche der getrockneten Beschichtungsschicht mit einem zweiten Nickelbinder, der Partikel aus Nickel und/oder einer Nickellegierung aufweist, und einem organischen Dispersionsmedium, zu beschichten, um eine Klebeschicht zu bilden,
einen Schritt zum Ausbilden eines Laminats, um das erste verbindbare Element und das zweite verbindbare Element über die getrocknete Beschichtungsschicht und die Klebeschicht aufeinander anzuordnen, um ein Laminat zu bilden, das das erste verbindbare Element und das zweite verbindbare Element aufweist, zwischen denen die getrocknete Beschichtungsschicht und die Klebeschicht dazwischen liegend sind, und
einen Schritt zum Ausbilden einer Verbindungsschicht, um das Laminat, das in dem Laminatbildungsschritt gebildet wurde, zu erhitzen und zu brennen, um eine Verbindungsschicht zu bilden, die aus einem gesinterten Körper aus Partikeln von Nickel und/oder einer Nickellegierung zwischen dem ersten verbindbaren Element und dem zweiten verbindbaren Element besteht,
wobei in einem beliebigen Querschnitt in der Verbindungsschicht eine Porosität von Hohlräumen, die einen kreisäquivalenten Durchmesser von 1 $\mu$m oder mehr haben, 30 % oder weniger beträgt,
wobei in einem beliebigen Querschnitt in der Verbindungsschicht eine Porosität von Hohlräumen, die einen kreisäquivalenten Durchmesser von weniger als 1 $\mu$m haben, 1% bis 50% beträgt,
wobei, als die Partikel aus Nickel oder einer Nickellegierung in dem Nickelbinder, Nanopartikel (Pn) mit einem mittleren Partikeldurchmesser von 15 nm bis 150 nm gemessen durch REM-Beobachtung und Mikropartikel (Pm) mit einem mittleren Partikeldurchmesser von 0,5 $\mu$m bis 10 $\mu$m gemessen durch REM-Beobachtung miteinander vorhanden sind, und wenn eine Querschnittsfläche der Nanopartikel (Pn) Sn ist und eine Querschnittsfläche der Mikropartikel (Pm) Sm ist, der Wert von Sn/(Sn+Sm) 0,2 bis 0,8 beträgt.

**6.** Verfahren zum Herstellen einer leitfähigen verbundenen Anordnung nach Anspruch 5, wobei die Klebeschicht abgeflacht wird, indem Konkavität und Komplexität an der Oberfläche der getrockneten Beschichtungsschicht versenkt wird.

## Revendications

**1.** Ensemble lié conducteur d'un constituant électronique présentant un premier élément liable, un second élément liable, et une couche de liaison conductrice positionnée entre le premier élément liable et le second élément liable et liant les deux éléments liables,
dans lequel ensemble lié conducteur d'un constituant électronique, ladite couche de liaison est un corps fritté de particules d'un ou des deux de nickel ou d'un alliage de nickel, et, dans toute section transversale dans ladite couche de liaison, une porosité de vides présentant un diamètre équivalent de cercle de 1 $\mu$m ou supérieur est de 30 % ou inférieure, et une porosité de vides présentant un diamètre équivalent de cercle inférieur à 1 $\mu$m est de 1 % à 50 %,
dans lequel en tant que les particules de nickel ou d'un alliage de nickel formant ladite couche de liaison, des nanoparticules (Pn) d'un diamètre moyen de particules de 15 nm à 150 nm mesuré par observation SEM et des microparticules (Pm) d'un diamètre moyen de particules de 0,5 $\mu$m à 10 $\mu$m mesuré par observation SEM sont coprésentes, et lorsqu'une surface transversale des nanoparticules (Pn) est Sn et une section transversale des microparticules (Pm) est Sm, la valeur de Sn/(Sn+Sm) est de 0,2 à 0,8.

**2.** Ensemble lié conducteur d'un constituant électronique selon la revendication 1, dans lequel à une surface de liaison dudit premier élément liable ou second élément liable avec ladite couche de liaison, une surface de contact dudit premier élément liable ou second élément liable avec ladite couche de liaison est de 90 % ou supérieure de la surface de liaison par observation par image fluoroscopique aux rayons X.

3. Ensemble lié conducteur d'un constituant électronique selon la revendication 1 ou 2, dans lequel à une surface de liaison dudit premier élément liable ou second élément liable avec ladite couche de liaison, il n'y a pas une partie de non-contact d'une dimension d'un diamètre équivalent de cercle de 1 mm ou supérieure par observation par image fluoroscopique aux rayons X.

4. Dispositif de semiconducteur muni d'un ensemble lié conducteur selon l'une quelconque des revendications 1 à 3, dans lequel ledit premier élément liable est un élément de métal et, de plus, ledit second élément liable est une pastille de semiconducteur présentant du silicium ou carbure de silicium comme un substrat.

5. Procédé de production d'un ensemble lié conducteur d'un constituant électronique selon l'une quelconque des revendications 1 à 3, présentant un premier élément liable, un second élément liable, et une couche de liaison conductrice positionnée entre le premier élément liable et le second élément liable et liant les deux éléments liables par des surfaces de liaison, ledit procédé de production d'un ensemble lié conducteur d'un constituant électronique comprenant :

une étape de formation de couche de revêtement revêtant une surface de liaison dudit premier élément liable ou second élément liable avec un premier liant de nickel contenant des particules de nickel et/ou d'un alliage de nickel et un milieu de dispersion organique pour former une couche de revêtement,
une étape de séchage rendant ladite couche de revêtement sèche pour former une couche de revêtement séchée,
une étape de formation de couche collante revêtant une surface de liaison de l'élément liable non formé avec la couche de revêtement séchée parmi lesdits premier élément liable et second élément liable et/ou la surface de ladite couche de revêtement séchée avec un second liant de nickel contenant des particules de nickel et/ou d'un alliage de nickel et un milieu de dispersion organique pour former une couche collante,
une étape de formation de stratifié superposant lesdits premier élément liable et second élément liable par l'intermédiaire de ladite couche de revêtement séchée et de la couche collante pour former un stratifié comprenant le premier élément liable et le second élément liable entre lesquels lesdites couche de revêtement séchée et couche collante sont intercalées, et
une étape de formation de couche de liaison chauffant et cuisant le stratifié formé dans ladite étape de formation de stratifié pour former une couche de liaison constituée d'un corps fritté de particules de nickel et/ou d'un alliage de nickel entre lesdits premier élément liable et second élément liable,
dans lequel dans toute section transversale dans ladite couche de liaison, une porosité de vides présentant un diamètre équivalent de cercle de 1 $\mu$m ou supérieur est de 30 % ou inférieure,
dans lequel, dans toute section transversale dans ladite couche de liaison, une porosité de vides ayant un diamètre de cercle équivalent inférieur à 1 $\mu$m est de 1 % à 50 %,
dans lequel, en tant que les particules de nickel ou d'un alliage de nickel dans ledit liant de nickel, des nanoparticules (Pn) d'un diamètre moyen de particules de 15 nm à 150 nm mesuré par observation SEM et des microparticules (Pm) d'un diamètre moyen de particules de 0,5 $\mu$m à 10 $\mu$m mesuré par observation SEM sont coprésentes, et lorsqu'une section transversale des nanoparticules (Pn) est Sn, et une section transversale des microparticules (Pm) est Sm, la valeur de Sn/(Sn+Sm) est de 0,2 à 0,8.

6. Procédé de production d'un ensemble lié conducteur selon la revendication 5, dans lequel ladite couche collante est aplanie par enfouissement de concavité et convexité sur la surface de ladite couche de revêtement séchée.

FIG. 1

# FIG. 2

EP 3 217 424 B1

# FIG. 3

50um

# FIG. 4

# FIG. 5

# FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5041454 B
- JP 2013069475 A
- JP 2012094873 A
- JP 2014029897 A
- JP 2011175871 A
- JP 2013177618 A

**Non-patent literature cited in the description**

- **TSUNEO ISHIDA.** Sintered Material Engineering. Morikita Publishing, 78